# EUROPÄISCHE PATENTSCHRIFT

(11) **EP 1 261 131 B1**
(45) Veröffentlichungstag und Bekanntmachung des Hinweises auf die Patenterteilung: **25.03.2009**
(21) Anmeldenummer: 02010271.1
(22) Anmeldetag: 17.05.2002
(51) Int. Cl.: H03K 17/95, G01V 3/10, H03K 17/965, H03K 17/972

(54) **Induktive Gangschalteinheit**
Inductive gear switching unit
Unité inductive de changement de vitesse

(30) Priorität: 23.05.2001 DE 10125278
(43) Veröffentlichungstag der Anmeldung: 27.11.2002
(73) Patentinhaber: Cherry GmbH, 91275 Auerbach (DE)
(72) Erfinder: Zapf, Martin, 95473 Creussen (DE); Kugler, Alexander, 91275 Auerbach (DE); Hahn, Gerhard, 91257 Pegnitz (DE)
(74) Vertreter: Leske, Thomas

(56) Entgegenhaltungen:
- EP-A1- 1 122 520
- WO-A-00/75535
- DE-A- 2 855 935
- DE-A- 3 506 239
- DE-A- 3 611 862
- DE-A- 4 335 701
- DE-A1- 19 650 154
- DE-C1- 19 741 367
- GB-A- 2 022 264
- GB-A- 2 197 076
- KARL KUPFMÜLLER: "Einführung in die theoretische Elektrotechnik" 1968, SPRINGER VERLAG Absatz 32 * Seite 278 *
- HERING, MARTIN, STOHRER: "Physik für Ingenieure" 1992, VDI VERLAG Absatz "Wirbelströme" * Seite 315 *
- GERTHSEN, KNESER: "Physik, Ein Lehrbuch zum Gebrauch neben Vorlesungen" 1966, SPRINGER VERLAG Absatz 44. Lentzsche Regel und Absatz 45. Induktion * Seite 232 *

## Beschreibung

Die vorliegende Erfindung betrifft eine Gangschalteinheit, welche zur Erzeugung von Schaltsignalen bestimmt ist.

Aus dem Stand der Technik sind unterschiedliche Schaltvorrichtungen bekannt, wobei die meisten Schaltvorrichtungen mechanische Schalter verwenden. Ein wesentlicher Nachteil dieser Schaltvorrichtungen besteht jedoch darin, daß diese zum Erzeugen von Schaltsignalen mechanische Schalteinheiten bzw. mechanische Mikroschalter und mechanische Schleifkontakte aufweisen. Die mechanischen Schalter haben den Nachteil, daß sie nicht verschleißfrei arbeiten. Ihre Lebensdauer wird einerseits durch Materialabtrag von Kontakten, durch Materialveränderung (Oxidation) bzw. durch Ablagerung auf den Schaltkontakten, welche durch mechanische Reibung, elektrische Überlastung oder das Auftreten eines Lichtbogens beim Abschalt- oder Umschaltvorgang hervorgerufen werden, begrenzt. Auch die Vibrationen der gesamten Kulissenschalteinheit führen zu einem erhöhten Verschleiß der Schleifkontakte und Schleifbahnen der mechanischen Schleifschalter.

Aus dem Stand der Technik sind andere Schalteinheiten bekannt, welche die nachteilige Verschleißeigenschaft der mechanischen Schaltkontakte beseitigen. Ein Beispiel für einen solchen verschleißfreien Schaltkontakt ist ein induktiver Schaltkontakt. Ein solcher induktiver Schaltkontakt in Form eines Drehschalters ist in der am 1. Februar 2000 beim Europäischen Patentamt eingereichten nicht vorveröffentlichten Patentanmeldung "Position Sensor" mit der amtlichen Nummer EP 00 101 661.7 beschrieben (EP 1 122 520 A1). Die genannte europäische Patentanmeldung weist die gleiche Anmelderin wie diese Anmeldung auf.

In DE 43 35 701 C2 ist eine induktive Winkelmesseinrichtung mit einer Magnetfluss-Führungseinrichtung in Form eines Schalenkerns aus ferritischen Material beschrieben. Eine Primärspule ist in den Schalenkern eingesetzt und erzeugt ein magnetisches Wechselfeld in einem Spalt. In diesem Spalt sind Sekundärspulen auf einem scheibenförmigen Spulenträger angeordnet. Ebenfalls im Spalt ist ein Messkörper mit einer elektrisch leitenden Beschichtung vorgesehen. Der Anteil des magnetischen Wechselfeldes, der die Sekundärspule durchsetzt, ist abhängig von der Relativstellung des Messkörpers zum Schalenkern. Von diesem stand der Technik geht die Erfindung aus.

In DE 36 11 862 A1 ist ein induktiver Näherungssensor dargestellt. Auch dort ist ein Schalenkern für einen Transformator vorgesehen. Eine Dämpfungswirkung tritt ein, wenn ein elektrisch leitendes Dämfungsglied an ein offenes Ende des Schalenkerns herangeführt wird. Die Sekundärspule ist - anders als bei DE 43 35 701 C2 - zusammen mit der Primärspule in Schalenkern angeordnet.

In DE 197 41 367 C1 ist ein elektrischer Schalter mit einem Schalthebel beschrieben. Primärspule und Sekundärspule sind planar angeordnet, wobei das positionsseitige Ende des Schalthebels mit einem Ferritkern versehen ist. Der Magnetfluss im Bereich des Sekundärspule wird durch den Ferritkern erhöht.

Es ist Aufgabe der vorliegenden Erfindung, eine Gangschalteinheit zu schaffen, welche den obengenannten Nachteil des Verschleißes - wie er bei mechanischen Schalterelementen vorliegt, überwindet und bei berührungsfreien Schalteinheiten einen einfacheren platzsparenderen und kostengünstigeren Aufbau aufweist.

Diese Aufgabe wird mit Hilfe einer Gangschalteinheit, welche die Merkmale des Patentanspruchs 1 aufweist, gelöst.

Die erfindungsgemäße Gangschalteinheit umfaßt mindestens eine planare Sensoreinheit_und mindestens eine Betätigungseinheit, wobei die Sensoreinheit auf eine relative räumliche Verschiebung der Sensoreinheit und der Betätigungseinheit zueinander durch Ausgabe von (der relativen Verschiebung entsprechenden)Schaltsignalen reagiert. Der Unterschied der erfindungsgemäßen Gangschalteinheit zu anderen aus dem Stand der Technik bekannten Positionsschaltvorrichtungen besteht darin, daß die Sensoreinheit als induktive planare Sensoreinheit und die Betätigungseinheit als induktive für einen Wirbelstrom leitfähige. Dämpfungseinheit ausgeführt worden sind.

Ein besonderer Vorteil der vorliegenden Erfindung wird mit Hilfe einer Gangschalteinheit erzeugt, in welcher entweder eine Betätigungseinheit gleichzeitig zwei oder mehr Sensoreinheiten betätigt oder die Gangschalteinheit mindestens zwei Betätigungseinheiten und mindestens drei Sensoreinheiten aufweist, wobei mindestens zwei der Betätigungseinheiten gleichzeitig mindestens zwei der Sensoreinheiten betätigen.

Die Funktionsweise der erfindungsgemäßen Gangschalteinheit kann am Beispiel nachfolgender Figuren verdeutlicht werden.
Figur 1 ist eine allgemeine schematiche Darstellung einer bevorzugten Ausführungsform der erfindungsgemäßen Gangschalteinheit.
Figur 2 ist ein Funktionsblockbild einer bevorzugten Ausführungsform einer induktiven Sensoreinheit.
Figur 3 ist eine schematische Darstellung der Funktionsweise der induktiven Sensoreinheit.
Figur 4 ist ein Beispiel für ein Schaltkriterium der induktiven Sensoreinheit.
Figur 5 ist eine mögliche Ausführung der induktiven Sensoreinheit..
Figur 6 zeigt ein Anwendungsbeispiel für die erfindungsgemäße Gangschalteinheit.
Figur 7 zeigt Ampltituden der Sensorsignale bei Schaltvorgängen eines in Figur 6 abgebildeten Automatikwählhebels von Postition 1 bis auf Position 4.
Figur 8 ist eine schematische Darstellung einer weiteren Ausführungsform der erfindungsgemäßen Gangschalteinheit.

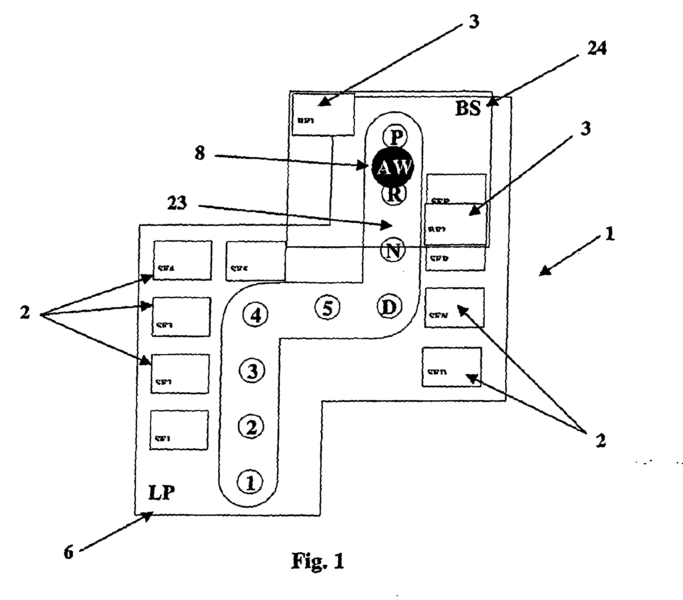

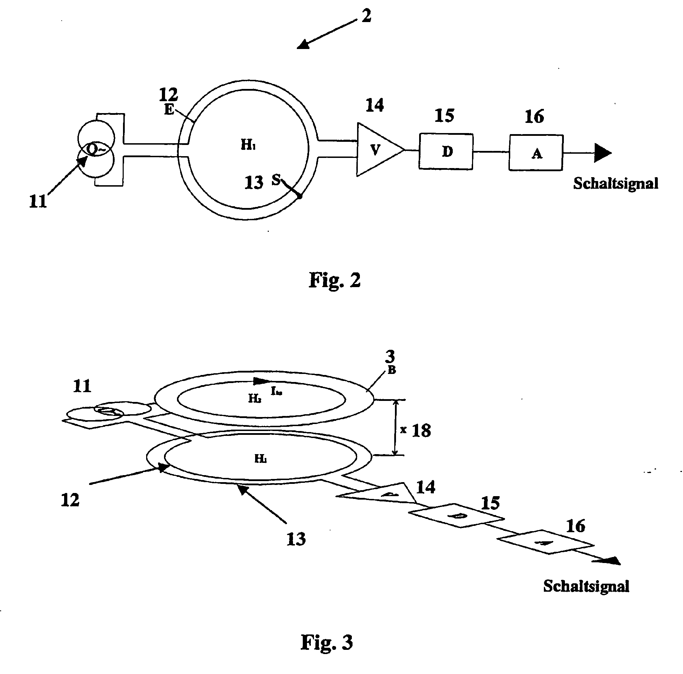

Figur 1 ist eine allgemeine schematische Darstellung einer bevorzugten Ausführungsform der erfindungsgemäßen Gangschalteinheit 1 zur Erzeugung von Gangschaltsignalen für ein automatisches Schaltgetriebe. Die Gangschalteinheit 1 weist Schalteinheiten 2 und mindestens eine Betätigungseinheit 3 auf, wobei die Betätigungseinheit 3 relativ zu den Schalteinheiten 2 verschiebbar ist. Die relative Verschiebung der Schalteinheiten 2 und der Betätigungseinheit 3 zueinander findet sowohl in horizontaler als auch in vertikaler Richtung statt. Unter Verschiebungsbewegungen ist damit eine reine Verschiebungsbewegung zu verstehen. Die Schalteinheiten 2 sind als induktive Sensoreinheiten und die Betätigungseinheit (3) als induktive Dämpfungseinheit ausgebildet, deren Funktionsweise mit Hilfe der Figuren 2 und 3 verdeutlicht ist.

Figur 2 zeigt eine bevorzugte Ausführungsform einer der induktiven Sensoreinheiten 2. Die induktive Sensoreinheit 2 besteht aus einer oszillierenden Stromquelle (Q∼) 11, einer planaren Erregerschleife (E) 12, einer planaren Sensorschleife (S) 13, einem Spannungsverstärker (V) 14, einem Amplitudendetektor (D) 15 und einer Auswerteeinheit (A) 16. Alle oder einige Komponenten 11 bis 16 der induktiven Sensoreinheit 2 können planar auf einer Leiterplatte 6 angeordnet werden. Dabei wird die Erregerschleife 12 von der Sensorschleife 13 umfaßt oder umgekehrt. Erreger 12 wie Sensorschleife 13 können auch mit mehreren Windungen ausgeführt werden.

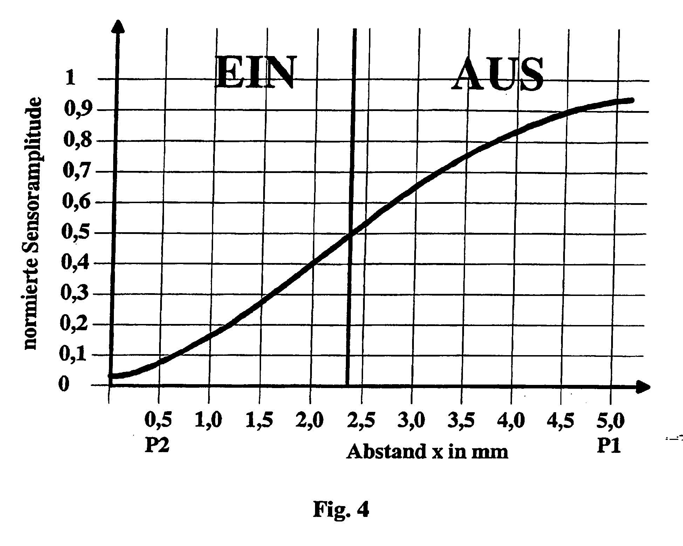

Die induktive Sensoreinheit 2 funktioniert folgendermaßen. Die oszillierende Stromquelle (Q∼) 11 prägt in die Erregerschleife 12 einen zeitlich veränderten elektrischen Strom ein. Dieser erzeugt ein zeitlich verändertes Magnetfeld M₁ der Feldstärke H₁(x,y,z). Der von der Sensorspule 13 umfaßte zeitlich veränderte magnetische Fluß bewirkt eine Spannung in der Sensorspule 13, wie in jedem elektrischen Leiter, der in die Nähe der Erregerspule 12 gebracht wird. Die Sensorspannung wird durch den Verstärker 14 verstärkt, die Amplitude mit dem Detektor 15 bestimmt und die Auswerteeinheit 16 vergleicht sie mit einem Schaltkriterium K. Figur 4 gezeigt ein Beispiel für das Schaltkriterium K. Bei einfachen Schaltern kann die Auswertung mittels eines Komparators oder eines Schmitt-Triggers realisiert werden. Die Auswerteeinheit 16 für Mehrfachschalter stellt dabei meist ein Microcontroller dar, der über eine Schnittstelle (CAN, LIN, etc.) die Schaltinformationen an die Steuerelektronik bzw. Leistungselektronik weitergibt.

Figur 3 ist eine schematische Darstellung der Funktionsweise der induktiven Sensoreinheit 2. Bringt man eine leitfähige Schicht, Platte oder Schleife als Betätigungseinheit (B) 17 in die Nähe der Erregerspule 12, durchdringt das Magnetfeld H₁ ebenfalls diese Betätigungseinheit 3 und induziert nach Lenz eine Spannung, die einen Wirbelstrom Iₖₛ hervorruft, der entgegengesetzt zum Strom in der Erregerspule fließt. Dieser ebenfalls zeitlich veränderte Kurzschlußstrom erzeugt ein Magnetfeld M₂, das entgegengesetzt zu M₁ wirkt und bei der Überlagerung der Felder damit zur Verringerung bis hin zu einer Auslöschung des Gesamtmagnetfeldes führt, das die Sensorspule 13 durchsetzt. Dies führt zu einer Verringerung der Sensorspannung und damit der Amplitude. Diese wird von der Auswerteeinheit 16 mit dem Schaltkriterium K verglichen und eine Schaltfunktion ausgelöst. Die Verringerung der Sensorspannung durch den Betätiger B kann auch als Dämpfung bezeichnet werden.

Die Dämpfung des Sensorsignals ist vom Abstand (x) 18 der Betätigungseinheit 3, welche als induktive Dämpfungseinheit ausgebildet ist, zur Sensorschleife 13 abhängig: bei x = 0 wird das Sensorsignal maximal gedämpft. Die induktive Dämpfungseinheit 5 kann aus unterschiedlichen elektrisch leitenden Materialien etwa aus Metall, aus einem leitenden Kunststoff usw. ausgeführt werden. Die Dämpfung ist auch vom Überdeckungsgrad der Sensorschleife 13 durch das Betätigungselement 3 bzw. durch die induktive Dämpfungseinheit 5 abhängig. Überdeckt die induktive Dämpfungseinheit 5 die gesamte Fläche der äußeren Schleife 13, so ist der Überdeckungsgrad 100% und die Amplitude des Sensorsignals ist dabei minimal. Damit werden für den Schalter zwei Schaltmechanismen möglich:
- Der Überdeckungsgrad G wird auf definierter Größe gehalten und der Abstand (x) 18 zwischen Betätigerelement 3 und Sensorschleife 13 variiert
- oder der Abstand (x) 18 wird konstant gehalten und der Überdeckungsgrad G wird verändert.
- Selbstverständlich ist auch eine Kombination aus beiden möglich.

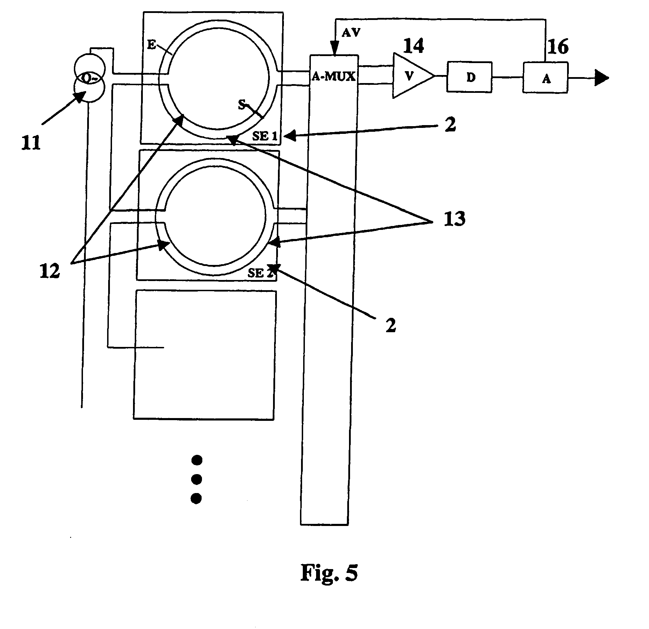

Die induktive Sensoreinheit 2 kann des weiteren auch so erweitert werden, daß eine Erregerspule 12 mehrere Sensorspulen 13 umschließt, die dann über einen Analogmultiplexer AMUX an den Verstärker angeschlossen werden. Denkbar ist auch, mehrere Erregerspulen in Reihenschaltung an die Stromquelle Q anzuschließen, die je eine oder mehrere Sensorspulen umschließen, wie dies etwa in Figur 5 gezeigt ist.

Weiterhin ist auch denkbar, pro Schaltposition zwei Betätigungseinheiten 3 und Sensorspulen 13 vorzusehen, um über eine Plausibilitätsabfrage eine höhere Redundanz zu schaffen. In einem solchen Fall müssen beide Schaltsignale jederzeit identisch sein.

Zudem ist es möglich, die Auswerteeinheit 16 so zu verändern, daß sie eine Schaltfunktion nicht durch Vergleich der Sensorspannung mit einem Schwellwert, sondern zusätzlich durch Vergleich mit der Spannung eines benachbarten Sensors auslöst.

Mit der induktiven Sensoreinheit 2 ist es möglich, auch einen Druckschalter wie folgt aufzubauen. Die Betätigungseinheit 3 wird an einen Stößel montiert, der ähnlich einer Kugelschreibermechanik in zwei Positionen alternierend verriegelbar ist. Es ist auch denkbar, die Mechanik des Druckschalters so zu gestalten, daß der Stößel keine Rastpositionen aufweist, sondern "frei" relativ zu der Sensoreinheit bzw. zu der Sensorschleifenebene verschiebbar ist. Beträgt der Abstand zwischen der Betätigungseinheit 3 und Sensorschleifenebene in (Rast-)Position P1 z.B. 5mm und in (Rast-)Position P2 0,5mm, so muß für das Schaltkriterium K für die in Bild 4 eingezeichneten Schaltbereich eine normierte Amplitudenspannung von etwa 0,5 eingestellt werden. Ein Druckschalter kann allerdings auch so ausgeführt werden, daß eine Mechanik den Überdeckungsgrad G des Betätigers relativ zur Sensorschleife 13 verändert. Dann hängt die Sensoramplitudenspannung vom Überdeckungsgrad G ab und muß nach deren Kennlinie festgelegt werden.

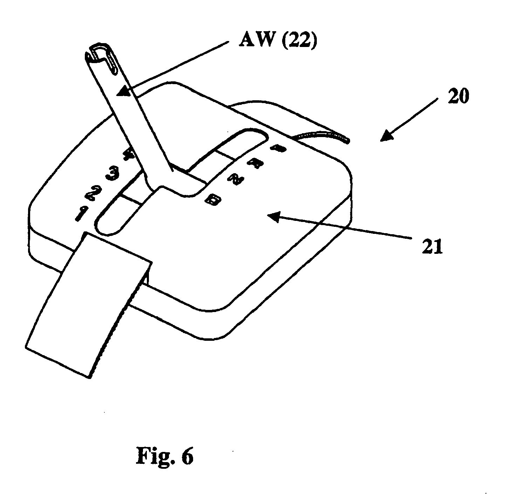

Im Falle, wenn mehrere Positionen zu detektieren sind, ist es zweckmäßig, mehrere Schalteinheiten 2 als Funktionseinheit zu kombinieren. Als Beispiel für die Verwendung einer erfindungsgemäßen Gangschalteinheit 1 ist in Fig. 6 eine Gangschaltvorrichtung 20 für ein automatisches Schaltgetriebe dargestellt. Die Fig.6 zeigt beispielhaft eine sog. Kulissenschalteinheit, wie sie vom Benutzer her gesehen als Stand der Technik allgemein bekannt ist. Neu ist allerdings eine Verwendung von induktiven Schaltern in Verbindung mit einer Kulissenschaltung. Besonders zweckmäßig sind diese induktive Schalterausführungen für eine Logiksteuerung, also für eine nicht direkt mechanische Auswahl der Gänge in einem automatischen Getriebe.

Unter der Blende bzw. Abdeckung 21 wird eine Leiterplatte 6 -wie in Figur 1 dargestellt- positioniert, auf deren Oberseite z.B die Hinterleuchtung der Blendenanzeigen ("1", "2".... "p") montiert werden kann. Mit dem Wählhebel 8 bzw. Automatikwählhebel (AW) 22, der durch einen Ausbruch 23 in der Leiterplatte taucht, ist ein Betätigerschlitten (BS) 24 verbunden, der auf der Unterseite der Leiterplatte LP 6 plan aufliegt und auf dem eine oder mehrere Betätigungseinheiten 3, hier z.B. zwei Betätigungseinheiten BF1 und BF2, angebracht sind, die in einem definierten Abstand über die verschiedenen induktiven Sensoreinheiten (SE*) 2 geschoben werden können. Die in Fig. 1 abgebildete Schalteinheit SE5 kann zur Erfassung einer weiteren Schaltposition des Wählhebels 22 verwendet werden. Diese Schaltposition kommt in Gangschaltvorrichtungen, die aus dem Stand der Technik allgemein bekannt sind, jedoch nicht vor. So weist z.B. die in Fig. 6 abgebildete Gangschaltvorrichtung 20 keine der Sensoreinheit SE5 entsprechende Schaltposition des Wählhebels auf. Diese Ausführung der Gangschaltvorrichtung ist somit optional, d.h. die Sensoreinheit SE5 kann weggelassen werden.

Bei der Kombination mehrerer induktiver Schalter stellt sich das Blockschaltbild wie dies in Figur 5 dargestellt ist. Eine Stromquelle 11 versorgt die Erregerspulen 12 von mehreren Sensoreinheiten (SE*) 4. Die Signale der Sensorschleifen 13 mehrerer Sensoreinheiten 2 werden über einen verschleißfreien Halbleiterschalter (AMUX) an den Verstärker 14 angeschlossen. Die Vorgabe, welche Sensoreinheit anzuschließen ist erhält AMUX von der Auswerteinheit 16 über die Adressvorgabe AV. Je nach Adressvorgabe gibt die Auswerteeineit 16 den Schaltzustand aus. Je nach Überdeckungsgrad von Betätigerfläche der Betätigungseinheit 3 und Sensoreinheit (SE*) 4 wird das zugehörige Sensorsignal gedämpft. Ist die an der Auswerteeinheit 16 einstellbare Schaltschwelle SW des Signals erreicht, wird die Position des Schalters als gültige Position erkannt und umgeschaltet.

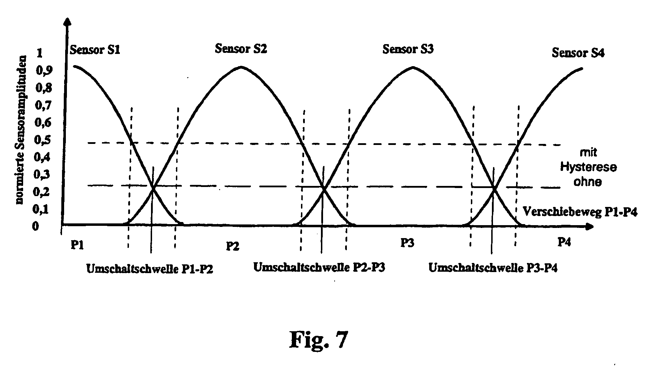

Eine Alternative zur bisher vorgeschlagenen Signalauswertung mit statischen Schwellwertvergleich ist, die Sensorsignale von zwei benachbarten Sensoreinheiten 2 zu vergleichen. Wird das Signal einer Sensoreinheit 2 niedriger als das der benachbarten Sensoreinheit 2 - wobei auch eine Hysterese mit berücksichtigt werden kann, wie in Figur 7 dargestellt - ist von einer Umschaltung von einer Position auf die andere auszugehen. Damit ergibt sich eine von äußeren Einflüssen wie Temperaturdrift des Verstärkers 14, der Stromquelle 11 usw., sehr unempfindliche Schaltschwellenfestlegung.

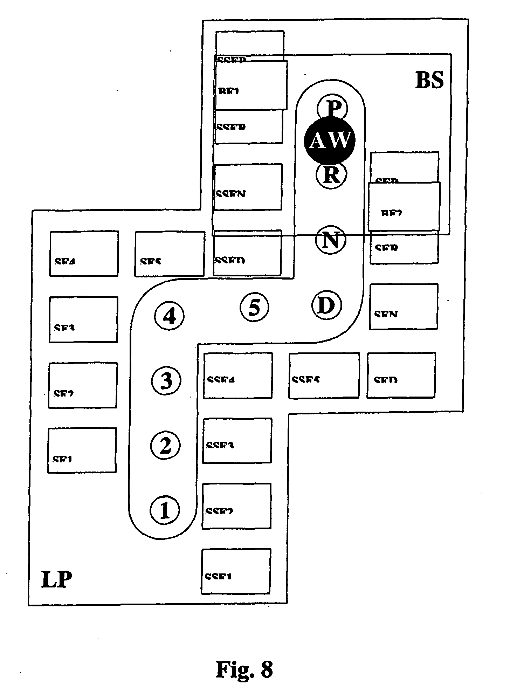

Auch eine extrem redundante Positionserkennung ist ohne großen Zusatzaufwand mit Hilfe der erfindungsgemäßen Gangschalteinheit 1 zu realisieren. Es wird vorgeschlagen, statt einer Sensoreinheit 2 pro Schaltposition mindestens zwei Sensoreinheiten 2 anzusetzen und die Signale weiter zu vergleichen. Bei widersprüchlichen Ergebnissen sollte die Auswerteeinheit 16 die Schaltfunktion so ausführen, daß das gesamte System in den sicheren Zustand gebracht wird. Die Leiterplatte 6 kann dazu etwa mit Sicherheits-Sensoreinheiten (SSE*) 2 ausgerüstet werden, wie dies schematisch in Fig. 8 dargestellt ist. Auch hier kann die Sensoreinheit SE5 und die korrespondierende Sicherheits-Sensoreinheit SSE5 zur Erfassung weiterer Positionen des Wählhebels 22 verwendet werden. Für eine in Fig. 6 abgebildete Gangschaltvorrichtung 20 kann eine derartige Schaltposition weggelassen werden.

Eine weitere Ausführungsform der erfindungsgemäßen Gangschalteinheit 1 ergibt sich, wenn anstatt von aus einer Sensoreinheit (SE*) 2 und einer Sicherheits-Sensoreinheiten (SSE*) 2, bestehenden Paaren, wie dies in Figur 8 dargestellt ist, nur eine Sensoreinheit 2 verwendet wird; z.B. anstatt SSEP und SEP nur SSEP; anstatt SSER und SER nur SER; anstatt SSEN und SEN nur SSEN usw. In diesem Fall sind die Sensoreinheiten 2 relativ weit voneinander auf der Leiterplatte 6 untergebracht. Diese Konstruktion der Gangschalteinheit 1 ermöglicht es, die durch Verschiebungen der Betätigungseinheiten 3 verursachten unerwünschten Nebendämpfungseffekte zu vermeiden.

## Patentansprüche

1. Gangschalteinheit umfassend mindestens eine Schalteinheit (2), die als induktive, planare Sensoreinheit, die eine von einer oszillierenden Stromquelle (11) mit einem elektrischen Strom geprägten Erregerspule (12) und mindestens eine Sensorspule (13) umfasst, ausgebildet ist, und mindestens eine Betätigungseinheit (3), wobei die Schalteinheit (2) auf eine relative räumliche Verschiebung der Schalteinheit (2) und der Betätigungseinheit (3) zueinander durch Ausgabe von entsprechenden Schaltsignalen reagiert, **dadurch gekennzeichnet, dass** die Betätigungseinheit (3) als induktive, für einen Wirbelstrom (I_{KS}) leitfähige Dämpfungseinheit ausgebildet ist.

2. Gangschalteinheit nach Anspruch 1, **dadurch gekennzeichnet, dass** mindestens zwei Schalteinheiten (2) auf einer gemeinsamen Trägereinheit (6) positioniert und/oder in eine gemeinsame Trägereinheit (6) integriert sind.

3. Gangschalteinheit nach Anspruch 2, **dadurch gekennzeichnet, dass** die Trägereinheit (6) eine Leiterplatte (7) ist.

4. Gangschalteinheit nach einem der obengenannten Ansprüche, **dadurch gekennzeichnet, dass** die Betätigungseinheit (3) horizontal und/oder vertikal relativ zu den Schalteinheiten (2) verschiebbar ist.

5. Gangschalteinheit nach einem der obengenannten Ansprüche, **dadurch gekennzeichnet, dass** die Betätigungseinheit (3) mit einem relativ zu den Schalteinheiten (2) verschiebbaren Betätigungselement (8, 22) verbunden ist, wobei eine bestimmte Position des Betätigungselementes (8, 22) relativ zu der Gangschalteinheit einer bestimmten Position der Betätigungseinheit (3) relativ zu den Schalteinheiten (2) entspricht.

6. Gangschalteinheit nach einem der obengenannten Ansprüche 1 bis 5, **dadurch gekennzeichnet, dass** mindestens zwei Betätigungseinheiten (3) vorhanden sind.

7. Gangschalteinheit nach Anspruch 6, welche redundante Schaltsignale ausgibt.

8. Gangschalteinheit nach Anspruch 7, **dadurch gekennzeichnet, dass** die redundanten Schaltsignale von zwei Sensoreinheiten (2) pro Schaltposition stammen und in einer Auswerteeinheit (16) verglichen werden.

9. Gangschalteinheit (20) nach einem der Ansprüche 1 bis 8, **dadurch gekennzeichnet, dass** die Schaltsignale Gangschaltsignale für ein automatisches Schaltgetriebe sind.

10. Gangschalteinheit nach Anspruch 9, **dadurch gekennzeichnet, dass** sie in Form einer Kulissenschalteinheit (20) ausgeführt ist.

## Claims

1. Gear shift unit comprising at least one shift unit (2) which is configured as an inductive, planar sensor unit which comprises an excitation coil (12), to which an electrical current is applied by an oscillating current source (11), and at least one sensor coil (13), and comprising at least one actuation unit (3), with the shift unit (2) reacting to a relative spatial displacement of the shift unit (2) and the actuation unit (3) with respect to each other by emitting corresponding shift signals, **characterised in that** the actuation unit (3) is configured as an inductive attenuation unit which can conduct an eddy current (IKS).

2. Gear shift unit according to Claim 1, **characterised in that** at least two shift units (2) are positioned on a common support unit (6) and/or are integrated in a common support unit (6).

3. Gear shift unit according to Claim 2, **characterised in that** the support unit (6) is a printed circuit board (7).

4. Gear shift unit according to one of the above-mentioned claims, **characterised in that** the actuation unit (3) can be displaced horizontally and/or vertically relative to the shift units (2).

5. Gear shift unit according to one of the above-mentioned claims, **characterised in that** the actuation unit (3) is connected to an actuation element (8, 22) which can be displaced relative to the shift units (2), with a certain position of the actuation element (8, 22) relative to the gear shift unit corresponding to a certain position of the actuation unit (3) relative to the shift units (2).

6. Gear shift unit according to one of the above-mentioned Claims 1 to 5, **characterised in that** at least two actuation units (3) are present.

7. Gear shift unit according to Claim 6, which emits redundant shift signals.

8. Gear shift unit according to Claim 7, **characterised in that** the redundant shift signals originate from two sensor units (2) per shift position and are compared in an evaluation unit (16).

9. Gear shift unit (20) according to one of Claims 1 to 8, **characterised in that** the shift signals are gear shift signals for an automatic transmission.

10. Gear shift unit according to Claim 9, **characterised in that** it is configured in the form of a gate type shift unit (20).

## Revendications

1. Unité de changement de vitesses comprenant au moins une unité de commutation (2), qui est configurée comme une unité à capteurs planaire, inductive, qui comprend une d'une source de courant (11) oscillante comportant une bobine d'excitation (12) sujette à un courant électrique et au moins une bobine de capteur (13), et au moins une unité d'actionnement (3), dans laquelle l'unité de commutation (2) réagit à un déplacement spatial relatif de l'unité de commutation (2) et de l'unité d'actionnement (3) l'une par rapport à l'autre en émettant des signaux de commutation correspondants, **caractérisée en ce que** l'unité d'actionnement (3) est configurée comme une unité d'amortissement inductive, conductrice d'un courant triphasé (Iks).

2. Unité de changement de vitesses selon la revendication 1, **caractérisée en ce que** au moins deux unités de commutation (2) sont positionnées sur une unité de support (6) commune et/ou sont intégrées dans une unité de support (6) commune.

3. Unité de changement de vitesses selon la revendication 2, **caractérisée en ce que** l'unité de support (6) est une carte de circuit imprimé (7).

4. Unité de changement de vitesses selon une des revendications ci-dessus, **caractérisée en ce que** l'unité d'actionnement (3) est déplaçable horizontalement et/ou verticalement par rapport aux unités de commutation (2).

5. Unité de changement de vitesses selon une des revendications ci-dessus, **caractérisée en ce que** l'unité d'actionnement (3) est reliée à un élément d'actionnement (8,22) déplaçable par rapport aux unités de commutation (2), dans laquelle une position déterminée de l'élément d'actionnement (8,22) par rapport à l'unité de changement de vitesses correspond à une position déterminée de l'unité d'actionnement (3) par rapport aux unités de commutation (2).

6. Unité de changement de vitesses selon une des revendications 1 à 5 ci-dessus, **caractérisée en ce que** au moins deux unités d'actionnement (3) sont présentes.

7. Unité de changement de vitesses selon la revendication 6, qui émet des signaux de commutation redondants.

8. Unité de changement de vitesses selon la revendication 7, **caractérisée en ce que** les signaux de commutation redondants proviennent de deux unités à capteurs (2) par position de commutation et sont comparés dans une unité d'évaluation (16).

9. Unité de changement de vitesses (20) selon une des revendications 1 à 8, **caractérisée en ce que** les signaux de commutation sont des signaux de changement de vitesse d'une boîte de vitesses automatique.

10. Unité de changement de vitesses selon la revendication 9, **caractérisée en ce que** elle est réalisée sous la forme d'une unité de commutation à coulisse (20).
